# EUROPEAN PATENT APPLICATION

(11) **EP 2 228 467 A2**
(43) Date of publication of application: **15.09.2010**
(21) Application number: 10156201.5
(22) Date of filing: 11.03.2010
(51) Int. Cl.: C25D 7/08, C25D 11/04, C25D 11/18, H01L 31/0336, H01L 31/0392

(54) **Aluminum alloy substrate and solar cell substrate**

(30) Priority: 11.03.2009 JP 2009058257
(71) Applicant: Fujifilm Corporation, Minato-ku Tokyo (JP)
(72) Inventor: Nishino, Atsuo, Shizuoka (JP); Uesugi, Akio, Shizuoka (JP); Sawada, Hirokazu, Shizuoka (JP)
(74) Representative: HOFFMANN EITLE

(57) **Abstract**

An aluminum alloy substrate having excellent insulating performance and withstand voltage characteristics and high strength at elevated temperatures, and a method of efficiently producing a flexible thin-film solar cell by a roll-to-roll process using the aluminum alloy substrate are provided. The substrate has an oxide film of more than 1 µm to 30 µm thickness having insulating properties on a surface of an aluminum alloy containing 2.0 to 7.0 wt% of magnesium, the balance being aluminum and inevitable impurities.

## Description

### BACKGROUND OF THE INVENTION

The present invention relates to an aluminum alloy substrate which is excellent in strength at elevated temperatures and in withstand voltage characteristics and is suitable for a thin-film solar cell substrate or a printed wiring board, and a solar cell substrate using the aluminum alloy substrate.

Solar cells are broadly classified into three types including (1) monocrystalline silicon solar cells, (2) polycrystalline silicon solar cells, and (3) thin-film solar cells. The monocrystalline silicon solar cells and polycrystalline silicon solar cells use a silicon wafer for the substrate, whereas the thin-film solar cells use a variety of substrates including glass substrate, metal substrate and resin substrate and have a thin light-absorbing layer formed on these substrates.

Thin films of silicon materials including amorphous silicon and nanocrystalline silicon and those of compounds including CdS/CdTe, CIS(Cu-In-Se), CIGS(Cu-In-Ga-Se) are used for the light-absorbing layer. Use of a flexible substrate enables continuous production of flexible solar cells by a roll-to-roll process in which an insulating layer and a thin film are formed as the substrate is wound into a roll.

Glass substrates are mainly used for the thin-film solar cells. However, the glass substrates are liable to fracture, require adequate care in handling and lack in flexibility. Recently, solar cells draw attention as the power supply source for houses or other buildings, and the solar cells are desired to have a larger size, a larger surface area and a decreased weight in order to ensure enough power supply. Under the circumstances, flexible substrate materials which are not liable to fracture and can achieve weight reduction, as exemplified by resin substrates, aluminum alloy substrates or the like have been proposed.

A known method involves forming an anodized layer or other insulating layer on the aluminum alloy substrate, then forming a thin-film solar cell layer thereon.

In order to form the compound thin film for the light-absorbing layer, a compound is disposed on the substrate and sintered at 350°C to 650°C in accordance with the type of compound used. Sintering at a temperature of 350 to 600°C and a line speed of 4 to 20 m/min is preferred in order to form, for example, the CIGS layer in the continuous production system, and it is desirable to use a substrate material withstanding such temperatures.

However, it is necessary to decrease the sintering temperature, because the shape of the aluminum substrate is difficult to hold due to lack of strength at elevated temperatures.

Exemplary known aluminum alloys having high strength at elevated temperatures include alloys containing iron and/or manganese, and JP 2008-81794 A proposes an improvement using an aluminum alloy containing 0.25 to 0.35 wt% of silicon, 0.05 to 0.3 wt% of iron, 0.3 to 0.5 wt% of copper, 1.2 to 1.8 wt% of manganese, 0.05 to 0.4 wt% of scandium, and 0.05 to 0.2 wt% of zirconium, the balance being aluminum and impurities; preferably containing 0.05 to 0.2 wt% of vanadium, 0.07 to 0.15 wt% of scandium and 0.07 to 0.1 wt% of zirconium, and more preferably containing 0.07 to 0.1 wt% of vanadium.

JP 2000-349320 A proposes specifying the shape of micropores in an anodized layer in a method of increasing the mechanical strength of the anodized layer provided on a flexible solar cell substrate using an aluminum alloy. The subject matter is an aluminum alloy-based insulating material having a pore-bearing anodized film with a thickness of at least 0.5 µm formed on a surface of an aluminum substrate, the anodized film having a plurality of voids extending within the anodized film in directions substantially orthogonal to the axes of the pores.

JP 2000-349320 A describes that an oxalic acid bath or a sulfuric acid bath may be applied for anodizing treatment but that the anodized film formed has a different internal structure depending on the alloy and treatment conditions and as a result various withstand voltage values are obtained. JP 2000-349320 A also describes that a higher withstand voltage can be achieved by a structure in which the pores and/or voids formed by anodizing treatment are filled with silicon oxide.

JP 2007-502536 A relates to a coated metallic material suited to manufacture of flexible solar cells and describes a method of manufacturing a metallic strip product coated with a metal oxide by a roll-to-roll process.

### SUMMARY OF THE INVENTION

In order to form the compound thin film for the light-absorbing layer of a thin-film solar cell, a compound is disposed on the substrate and sintered at 350°C to 650°C in accordance with the type of compound used. Sintering at a temperature of 350 to 600°C and a line speed of 1 to 30 m/min is preferred in order to form, for example, the CIGS layer in the continuous production system, and it is desirable to use a substrate material withstanding such temperatures.

However, it is necessary to decrease the sintering temperature, because the shape of the aluminum substrate is difficult to hold due to lack of strength at elevated temperatures. Aluminum alloys having high strength at elevated temperatures such as iron and/or manganese-containing alloys are known in JP 2008-81794 A, but these elements do not easily enter into solid solution and are likely to produce intermetallic compounds with aluminum. As a result, these intermetallic compounds cause a defect of the anodized film, thus decreasing the insulation properties. Therefore, it has heretofore been necessary to increase the thickness of the anodized film.

An exemplary known method of increasing the strength of the aluminum plate is a method in which soaking and/or intermediate annealing is omitted so that recrystallization of aluminum is not easily carried out and the draft is further increased in the cold rolling step to increase the strength of the aluminum plate by work hardening. However, it is necessary to increase the number of times cold rolling is carried out to achieve a desired plate thickness, scratching and adhesion of dust take place during rolling, and therefore this method is not preferred.

The present invention has found an aluminum alloy component which is suitable for use in a thin-film solar cell substrate or a printed wiring board and is excellent in strength at elevated temperatures and in which the intermetallic compound does not cause a defect of the anodized film. It has been found that an aluminum alloy substrate having excellent insulating performance and withstand voltage characteristics and high strength at elevated temperatures is obtained by providing an aluminum oxide film having insulating properties on the aluminum alloy surface, and the present invention has been thus completed.

An object of the present invention is to provide an aluminum alloy having an anodized film which is excellent in strength at elevated temperatures and withstand voltage characteristics. Another object of the present invention is to provide an aluminum alloy substrate using such aluminum alloy. Still another object of the present invention is to provide a method of manufacturing a thin-film solar cell.

The aluminum alloy, the aluminum alloy substrate, the solar cell substrate, and the thin-film solar cell and its manufacturing method according to the present invention have the following characteristic features.
(1) A substrate comprising: an oxide film having insulating properties on a surface of an aluminum alloy containing 2.0 to 7.0 wt% of magnesium, the balance being aluminum and inevitable impurities. The oxide film preferably has a thickness of more than 1µm to 30um.
(2) The substrate according to (1), wherein the oxide film having the insulating properties is a porous anodized film with a thickness of 5 to 30 µm.
(3) The substrate according to (1) or (2), wherein the porous anodized film is one obtained by anodizing the aluminum alloy in an aqueous sulfuric or oxalic acid solution.
(4) The substrate according to any one of (1) to (3),
   wherein the oxide film having the insulating properties is one obtained by forming a porous anodized film through anodization of the aluminum alloy in an aqueous sulfuric or oxalic acid solution, and sealing the porous anodized film in an aqueous boric acid solution containing sodium borate.
(5) A substrate comprising: an insulating layer formed on a surface of an aluminum alloy containing 2.0 to 7.0 wt% of magnesium, the balance being aluminum and inevitable impurities. The insulating layer preferably has a thickness of more than 1µm to 30µm.
(6) A solar cell substrate comprising: an aluminum alloy containing 2.0 to 7.0 wt% of magnesium, the balance being aluminum and inevitable impurities; and an insulating layer formed on a surface of the aluminum alloy. The insulating layer preferably has a thickness of more than 1µm to 30µm.
(7) A solar cell substrate obtained by a process which comprises: providing an aluminum alloy containing 2.0 to 7.0 wt% of magnesium, the balance being aluminum and inevitable impurities; anodizing the aluminum alloy in an aqueous sulfuric or oxalic acid solution to form a porous anodized film with a thickness of 5 to 30 µm; and sealing the porous anodized film in an aqueous boric acid solution.
(8) A solar cell having the substrate according to any one of (1) to (7).
(9) A thin-film solar cell comprising the substrate according to any one of (1) to (7) and a light-absorbing layer formed on the substrate, with a backside electrode layer interposed between the substrate and the light-absorbing layer.
(10) The thin-film solar cell according to (9), wherein the light-absorbing layer contains a compound selected from the group consisting of CdS/CdTe, CIS, and CIGS.
(11) A method of manufacturing a thin-film solar cell comprising the steps of: continuously feeding an aluminum alloy plate which is wound into a roll and contains 2.0 to 7.0 wt% of magnesium, the balance being aluminum and inevitable impurities; subjecting the fed aluminum alloy plate to anodizing treatment, rinsing with water, sealing treatment, rinsing with water and drying; winding the aluminum alloy plate having been dried into a roll; and continuously feeding the aluminum alloy plate having been wound into the roll to form a backside electrode layer and a light-absorbing layer.

The aluminum alloy substrate of the present invention is one having excellent insulating performance and withstand voltage characteristics and high strength at elevated temperatures. A flexible thin-film solar cell can be efficiently produced by a roll-to-roll process using the aluminum alloy substrate of the present invention.

### BRIEF DESCRIPTION OF THE INVENTION

FIG. 1A schematically shows a cross-section of an embodiment of an anodized film in its growth direction and FIG. 1B shows in cross-section another embodiment.
FIG. 2 is a cross-sectional view showing an example of the general configuration of a thin-film solar cell for which the substrate of the present invention can be used.
FIG. 3 schematically shows an exemplary device that may be used in anodizing treatment and electrochemical sealing treatment of the present invention.

### DETAILED DESCRIPTION OF THE INVENTION

### 1. Aluminum Alloy Plate

The aluminum alloy that may be used in the present invention contains 2.0 to 7.0 wt% of magnesium, with the balance being aluminum and inevitable impurities. The aluminum alloy member is not particularly limited for its shape but is mainly in plate form when used for the substrate of solar cells. In the following, the aluminum alloy member is described with reference to an alloy plate and is often referred to as "aluminum plate".

The aluminum alloy and the aluminum alloy plate contain 2.0 to 7.0 wt% of magnesium, with the balance being aluminum and inevitable impurities. The magnesium content is preferably 2.5 to 6.5 wt% and more preferably 3.5 to 6.0 wt%.

Magnesium easily enters into solid solution in aluminum and is less likely to produce intermetallic compounds, and therefore a decrease in the insulating properties due to a defect in an anodized film is unlikely to occur.

The aluminum alloy contains aluminum and inevitable impurities as the balance. Most of the inevitable impurities originate from the aluminum ingot. If the inevitable impurities are what is present in an ingot having an aluminum purity of 99.7% to 99.99%, they will not compromise the intended effects of the invention. The inevitable impurities may be, for example, impurities included in the amounts mentioned in Aluminum Alloys: Structure and Properties, by L.F. Mondolfo (1976). The aluminum alloy may contain as the inevitable impurities one or more elements selected from the group consisting of Zn, Ti, B, Ga, Ni, Li, Be, Sc, Mo, Ag, Ge, Ce, Nd, Dy, Au, K, Rb, Cs, Sr, Y, Hf, W, Nb, Ta, Tc, Re, Ru, Os, Rh, Ir, Pd, Pt, In, Tl, As, Se, Te, Po, Pr, Sm, Tb, Ba, Co, Cd, Bi, La, Na, Ca, Zr, Cr, V, P, and S, the content of each of the elements being from 0.001 to 100 ppm.

At least one of Si, Fe, Cu, Mn, Zn, Cr, Ti, Pb, Ni, Ga, Zr, V, Sc, B, and Na is preferably included in the aluminum alloy and aluminum alloy plate in an amount of 0 to 0.008 wt% (0 to 80 ppm), more preferably 0 to 0.006 wt% (0 to 60 ppm) and most preferably 0 to 0.005 wt% (0 to 50 ppm).

The aluminum alloy that may be used in the present invention is subjected to melting of the material, casting into a slab, billet or ingot, scaling, intermediate annealing, soaking, cold rolling, and correction by an ordinary method, and is further extruded, rolled or otherwise treated to form a plate with a desired thickness which is suitable for use in a thin-film solar cell substrate. Heat treatment, aging, cleaning and other treatment in these steps are also appropriately performed by an ordinary method. In the most preferred embodiment, the aluminum alloy of the present invention contains 2.0 to 7.0 wt% of magnesium by the addition of magnesium to pure aluminum with an aluminum purity of 99.99%.

The aluminum alloy of the present invention has high strength at elevated temperatures and therefore can be used for the material of various members that require high strength in a high temperature range, and is a particularly preferred material of a thin-film solar cell substrate.

The aluminum alloy plate of the present invention has a thickness of 20 to 5000 µm and a plate width of 10.0 to 2000 mm.

The surface of the aluminum plate is preferably mirror-finished and the surface roughness Ra is preferably from 0.1 nm to 2 µm and more preferably from 1 nm to 0.3 µm.

Exemplary methods of mirror-finishing an aluminum plate are described in JP 4212641 B, JP 2003-341696 A, JP 7-331379 A, JP 2007-196250 A and JP 2000-223205 A.

In a preferred embodiment, the aluminum alloy plate of the present invention has a tensile strength at room temperature of 250 to 600 MPa and a tensile strength following heating at 550°C for 1 hour of 100 to 300 MPa.

The 0.2% proof stress is preferably from 150 to 350 MPa at room temperature and from 50 to 150 MPa following heating at 550°C for 1 hour.

The aluminum alloy plate preferably has an elongation of 1 to 10% at room temperature and an elongation of 20 to 50% following heating at 550°C for 1 hour.

### 2. Substrate

The substrate of the present invention has an insulating layer formed on a surface of the aluminum alloy.

The insulating layer is not particularly limited. The substrate of the present invention is suitable to the solar cell substrate.
1) The substrate in a first embodiment of the present invention has at the surface of the aluminum alloy an anodized film which serves as the insulating layer.
2) In the substrate according to a second embodiment of the present invention, the insulating layer is not limited and may be one containing, for example, at least one oxide layer, the oxide layer comprising at least one dielectric oxide selected from the group consisting of Al₂O₃, TiO₂, HfO₂, Ta₂O₅, and Nb₂O₅, Alternatively, the insulating layer may be a conventionally known resin layer or glass layer.

Other examples of the insulating layer that have been proposed include a resin insulating layer, an inorganic insulating layer, a metal oxide layer, and an anodized layer. For example, JP 59-47776 A describes forming a polymer resin film with a thickness of about 2 µm by applying a liquid resin to the surface of a stainless steel substrate and baking it at a high temperature. JP 59-4775 A describes forming an insulating film of SiO₂ Al₂O₃, SiNx or the like by sputtering, vapor deposition, ion plating, plasma CVD or thermal decomposition CVD. JP 2-180081 A describes forming an insulating film using a coating material which includes as its main component an organic silicate containing insulating fine particles.

The substrate in the first embodiment of the present invention as mentioned in 1) above is described below.

### 3. Anodization

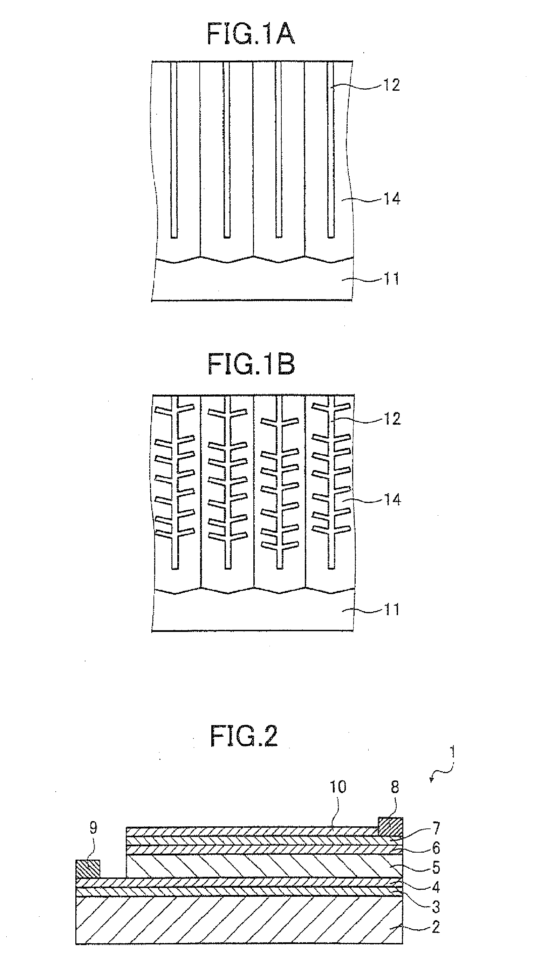

The substrate in the first embodiment of the present invention has an anodized film at a surface of the aluminum alloy plate. In the case of baking at high temperatures as in a solar cell substrate, as the anodized film has more voids called "micropores" and the voids are disposed randomly, a higher crack-suppressing effect and excellent flexibility are achieved. The micropores grow in a direction perpendicular to the aluminum plate, but the aluminum plate more preferably has an obliquely or laterally branched structure in order to achieve a higher resistance to cracking of the anodized film. FIGS. 1A and 1B each schematically show a cross-section of the anodized film in its growth direction. FIG. 1A shows an example in which micropores 12 grow in aluminum oxide (anodized film) 14 perpendicularly with respect to an aluminum substrate 11, and FIG. 1B shows an exemplary structure in which micropores 12 are branched obliquely or laterally with respect to an aluminum substrate 11. These differences may arise from combinations of the aluminum alloy components and the components of the anodizing treatment solution with the anodizing treatment conditions such as AC superimposition and the electrolysis conditions such as current inversion.

Depending on the combination with the AC superimposition, the current inversion or other electrolysis conditions, it is possible to obtain an anodized film of an internal structure which has pores extending within the anodized film in its growth direction and voids extending in a direction substantially perpendicular to the pores.

An oxalic acid bath, a phosphoric acid bath, a chromic acid bath, a boric acid bath, a tartaric acid bath, a citric acid bath, a malic acid bath, a succinic acid bath, an acetic acid bath, a malonic acid bath or a sulfuric acid bath may be used for the anodizing bath, but the internal structure of the anodized film varies with the anodizing conditions and as a result various withstand voltage values are obtained. Among them, an oxalic acid bath or a sulfuric acid bath is preferable.

FIG. 1B shows an example of anodizing an aluminum alloy plate using a chromic acid bath.

The micropores preferably have a diameter of 10 to 600 nm. The micropores preferably have a depth of 0.005 to 299.995 nm. The micropores are preferably formed at a density of 100 to 10000 micropores/µm².

The anodized film preferably has a thickness of more than 1 to 30 µm, preferably 1.5 to 30 µm, more preferably 3 to 30 µm, 5 to 30 µm, 5 to 28 µm and most preferably 5 to 25 µm.

The anodized film has a barrier layer with a thickness of preferably 0.005 nm to 200 nm.

The anodized film preferably has a surface roughness Ra of 0.1 nm to 2 µm, and more preferably 1 nm to 0.3 µm.

The anodized film has a surface topography as defined by a fractal analysis, wavelet analysis or Fourier transform method and preferably has a fractal dimension in a unit length of 1 nm to 1000 µm, of greater than 2 but not more than 2.99.

Preferred anodizing treatment conditions are described below.

It is possible to use an AC, a DC or an AC/DC superimposed current for anodizing treatment, and the current may be applied at a constant rate from the initial stage of electrolysis or using an incremental method. However, a method using a DC is particularly preferred. The thickness of the anodized film may be adjusted with the electrolysis time.

The front and back sides of the aluminum plate may be anodized simultaneously or sequentially.

It is possible to use a known anodizing method for the electrolyte flow rate on the aluminum surface and its application method, electrolytic cell, electrode, and method of controlling the electrolyte concentration. For example, the thickness of the anodized film may be adjusted with the electrolysis time.

Exemplary methods are described in JP 2002-362055 A, JP 2003-001960 A, JP 6-207299 A, JP 6-235089 A, JP 6-280091 A, JP 7-278888 A, JP 10-109480 A, JP 11-106998 A, JP 2000-17499 A, JP 2001-11698 A, and JP 2005-60781 A. It is possible to use, for example, aluminum, carbon, titanium, niobium, zirconium, and stainless steel for the counter electrode (cathode) of the aluminum plate serving as the anode. It is possible to use, for example, lead, platinum, and iridium oxide for the counter electrode (anode) of the aluminum plate serving as the cathode.

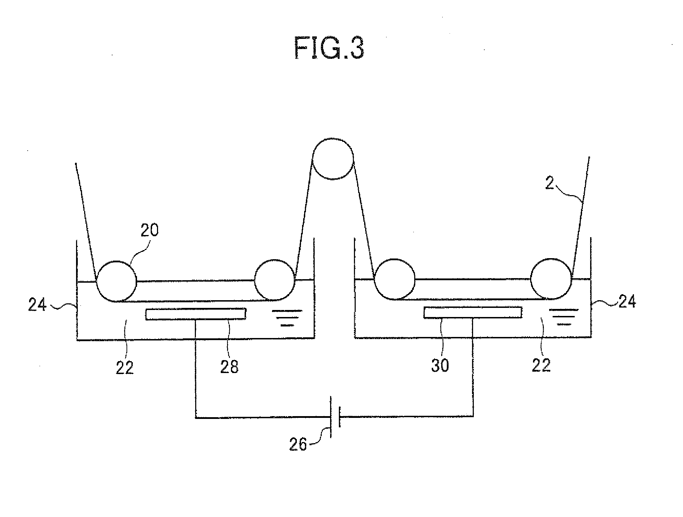

FIG. 3 shows an exemplary device that may be used in anodizing treatment and electrochemical sealing treatment of the present invention. This device is used to electrochemically treat the surface of an aluminum alloy plate 2 which is made to travel through a plurality of pass rolls 20 within an electrolytic cell 24 containing an electrolytic solution 22, with a DC power supply 26 connected to an anode 28 and a cathode 30 disposed so as to face the aluminum alloy plate 2.

### (a) Anodizing Treatment in Aqueous Sulfuric Acid Solution

The aluminum alloy plate serving as an anode is anodized under the conditions of a sulfuric acid concentration of 100 to 300 g/L and preferably 120 to 200 g/L (and an aluminum ion concentration of 0 to 10 g/L), a solution temperature of 10 to 55°C (and preferably 20 to 50°C), a current density of 1 to 100 A/dm² (and preferably 3 to 80 A/dm²), and an electrolysis time of 10 to 3000 seconds (and preferably 30 to 1000 seconds). The voltage between the aluminum plate and the counter electrode is preferably from 10 to 150 V and varies with, for example, the composition of the electrolytic cell, solution temperature, flow rate at the aluminum interface, power supply waveform, distance between the aluminum plate and the counter electrode, and electrolysis time.

The aluminum ions electrochemically or chemically dissolve in the electrolytic solution but it is particularly preferable to add aluminum sulfate to the electrolytic solution in advance.

The magnesium ions electrochemically or chemically dissolve in the electrolytic solution but it is particularly preferable to add magnesium sulfate to adjust the magnesium ion concentration to 0 to 10 9/L in advance. Trace elements contained in the aluminum alloy may dissolve therein.

### (b) Anodizing Treatment in Aqueous Oxalic Acid Solution

The aqueous oxalic acid solution preferably contains 10 to 150 g/L (and preferably 30 to 100 g/L) of oxalic acid and 0 to 10 g/L of aluminum ions. The aluminum alloy plate serving as an anode is anodized under the conditions of a solution temperature of 10 to 55°C (and preferably 10 to 30°C), a current density of 0.1 to 50 A/dm² (and preferably 0.5 to 10 A/dm²), and an electrolysis time of 1 to 100 minutes (and preferably 30 to 80 minutes). The voltage between the aluminum plate and the counter electrode is preferably from 10 to 150 V and varies with, for example, the composition of the electrolytic cell, solution temperature, flow rate at the aluminum interface, power supply waveform, distance between the aluminum plate and the counter electrode, and electrolysis time.

The aluminum ions electrochemically or chemically dissolve in the electrolytic solution but aluminum oxalate may be added to the electrolytic solution in advance.

The magnesium ions electrochemically or chemically dissolve in the electrolytic solution but magnesium oxalate may be added to the electrolytic solution to adjust the magnesium ion concentration to 0 to 10 g/L in advance. Trace elements contained in the aluminum alloy may dissolve therein.

Degreasing and cleaning before anodizing treatment is an optional step and, if it is to be carried out, is preferably carried out by immersion in an aqueous acid or alkali solution or by spraying, and immersion in an aqueous acid solution is particularly preferred. Thereafter, rinsing with water may be carried out. The aqueous solution preferably has a temperature of 10 to 70°C and the degreasing time is preferably 1 to 60 seconds. It is particularly preferred for the aqueous acid solution used to be of the same type as that used in anodizing treatment.

### 4. Sealing Treatment

It is preferred for the aluminum alloy plate having undergone anodizing treatment to be then subjected to sealing treatment.

Electrochemical methods and chemical methods are known for sealing treatment, but an electrochemical method using an aluminum plate serving as the anode (anodizing treatment) is particularly preferred.

The electrochemical method is preferably a method in which sealing treatment is carried out by applying a direct current to the aluminum alloy serving as the anode. The electrolytic solution is preferably an aqueous boric acid solution, and an aqueous solution obtained by adding a sodium-containing borate to the aqueous boric acid solution is preferred. Examples of the borate include disodium octaborate, sodium tetraphenylborate, sodium tetrafluoroborate, sodium peroxoborate, sodium tetraborate and sodium metaborate. These borates are available in the form of anhydride or hydrate.

It is particularly preferred to use, as the electrolytic solution for sealing treatment, an aqueous solution obtained by adding 0.01 to 0.5 mol/L of sodium tetraborate to an aqueous solution containing 0.1 to 2 mol/L boric acid.

The electrolytic solution preferably contains 0 to 0.1 mol/L of aluminum ions dissolved therein.

The aluminum ions are chemically or electrochemically dissolved in the electrolytic solution by sealing treatment but a method of electrolysis by previous addition of aluminum borate is particularly preferred.

The electrolytic solution may contain 0 to 0.1 mol/L of magnesium ions dissolved therein. Trace elements contained in the aluminum alloy may dissolve therein.

The insulating film has sodium in its interior or on its surface by the addition of sodium borate and a solar cell substrate using such insulating film can exhibit particularly excellent properties.

Preferred conditions for sealing treatment include a solution temperature of 10 to 55°C (and preferably 10 to 30°C), a current density of 0.01 to 5 A/dm² (and preferably 0.1 to 3 A/dm²), and an electrolysis time of 0.1 to 10 minutes (and preferably 1 to 5 minutes).

It is possible to use an AC, a DC or an AC/DC superimposed current, and the current may be applied at a constant rate from the initial stage of electrolysis or using an incremental method. However, a method using a DC is particularly preferred.

A current may be applied by a constant voltage process or a constant current process.

The voltage between the aluminum plate and the counter electrode is preferably from 100 to 1000 V and varies with, for example, the composition of the electrolytic cell, solution temperature, flow rate at the aluminum interface, power supply waveform, distance between the aluminum plate and the counter electrode, and electrolysis time.

The front and back sides of the aluminum plate may be sealed simultaneously or sequentially.

It is possible to use the known anodizing methods described in connection with anodizing treatment and sealing methods for the electrolyte flow rate on the aluminum surface and its application method, electrolytic cell, electrode, and method of controlling the electrolyte concentration.

In a preferred chemical method, a higher withstand voltage can be achieved by a structure in which the pores and/or voids after anodizing treatment are filled with silicon oxide. It is also possible to obtain a further increased withstand voltage by a method of filling the pores and/or voids with silicon oxide which involves applying a solution containing a Si-O bond-bearing compound or immersing in an aqueous sodium silicate solution (aqueous solution containing 1 to 5 wt% of No. 1 sodium silicate or No. 3 sodium silicate, 20 to 70°C) for 1 to 30 seconds, rinsing with water, drying, and further baking at 200 to 600°C for 1 to 60 minutes. Immersion in the aqueous sodium silicate solution enables the sodium component to be diffused in the CIGS film, thus further increasing the power generation efficiency.

An exemplary chemical method that may be preferably used to further increase the power generation efficiency includes a method in which the aqueous sodium silicate solution is replaced by a 1 to 5 wt% aqueous solution containing sodium hexafluorozirconate and/or sodium dihydrogen phosphate or a mixture thereof at a mixing weight ratio of 5:1 to 1:5, and sealing treatment is carried out by immersion in the latter solution at 20 to 70°C for 1 to 60 seconds.

Chemical sealing method uses simpler equipment than electrochemical sealing method and is therefore preferred for mass production of solar cell substrates.

### 5. Method of Manufacturing Solar Cell

A thin-film solar cell can be manufactured by the roll-to-roll process. In other words, a substrate wound into a roll after having been molded so as to have a specified thickness travels from a feed roll to a take-up roll and the respective layers to be described later are sequentially formed or each layer is formed during the travel of the substrate to be taken up by the take-up roll.

It is particularly preferred for the aluminum alloy substrate of the present invention to be anodized and sealed by the roll-to-roll process.

It is preferred to use a method in which the aluminum alloy plate taken up after the foregoing treatments have been carried out is fed again to sequentially form thereon the respective layers to be described later, and then cut to obtain solar cells. It is also preferred to use a method in which solar cells are formed after cutting the aluminum alloy plate having undergone anodizing treatment and sealing treatment.

### 6. Thin-Film Solar Cell

FIG. 2 is a cross-sectional view showing an example of the general configuration of a thin-film solar cell 1 for which the substrate of the present invention can be used.

The inventive aluminum substrate having an insulating layer 3 on an aluminum alloy plate 2 is used. A backside electrode layer 4 is then formed on the insulating layer 3, and a light-absorbing layer 5, a buffer layer 6, and a transparent electrode layer 7 are sequentially formed, with output electrodes 8 and 9 formed on the transparent electrode layer 7 and the backside electrode layer 4, respectively. The exposed portion of the transparent electrode layer 7 is coated with an antireflective film 10. The insulating layer 3 may be that of the substrate in the first embodiment of the present invention having the anodized film as its main element, or that of the substrate in the second embodiment of the present invention obtained by forming any known insulating layer on the aluminum alloy plate that may be used in the invention.

The thin-film solar cell illustrated in FIG. 2 is not particularly limited for the materials and thicknesses of the insulating layer 3, backside electrode layer 4, light-absorbing layer 5, buffer layer 6, transparent electrode layer 7 and output electrodes 8, 9. For example, the respective layers of the CIS or CIGS thin-film solar cell may be made of the following materials and have the thicknesses defined below.

The insulating layer 3 of the present invention based on the porous anodized film preferably has a thickness of more than 1 µm to 30 µm, more preferably 3 to 28 µm, 3 to 25 µm and most preferably 5 to 25 µm.

The backside electrode layer 4 is made of an electrically-conductive material and has a thickness of 0.1 to 1 µm. Film deposition may be carried out by techniques commonly used in manufacture of solar cells, as exemplified by sputtering and vapor deposition. The material is not particularly limited as long as it has electrical conductivity, and use may be made of a metal or a semiconductor having a volume resistivity of 6 × 10⁶ Ω · cm or less. More specifically, for example, Mo (molybdenum) may be deposited. The shape is not particularly limited and films may be deposited in an arbitrary shape in accordance with the required shape of the solar cell.

In order to increase the power generation efficiency, the light-absorbing layer 5 requires the function of efficiently absorbing light to excite electron-hole pairs and take out the excited electron-hole pairs without recombination. It is important to use a film having a larger light absorption coefficient in order to obtain a higher power generation efficiency. Silicon thin films such as amorphous silicon thin films and nanocrystalline silicon thin films or thin films made of various compounds are used for the light-absorbing layer 5. The type of compound is not limited and use may be made of compounds such as CdS/CdTe, CIS(Cu-In-Se), CIGS(Cu-In-Ga-Se), SiGe, CdSe, GaAs, GaN, and InP. The thin films made of these compounds can be formed by methods such as sintering, chemical deposition, sputtering, close-spaced sublimation, multi-source deposition and selenization.

The thin film made of CdS/CdTe is a thin laminated film obtained by sequentially forming a CdS film and a CdTe film on the substrate (aluminum substrate having the insulating layer), and is classified depending on the thickness of the CdS film into two types including (a) a film having a thickness of about 20 µm and (b) a film having a thickness of 0.1 µm or less with a transparent conductive film formed between the film and the substrate. In the structure of (a), CdS paste and CdTe paste are sequentially applied onto the substrate and sintered at a temperature of 600°C or less. In the structure of (b), the CdS film is formed by chemical deposition or sputtering and the CdTe film is formed by close-spaced sublimation.

The CIS or CIGS thin film uses a compound semiconductor and is characterized by the high stability with respect to the long-term use. The thin film made of any of these compounds has a thickness of, for example, 0.1 to 4 µm and is formed by applying a compound paste and sintering at a temperature of 350 to 550°C.

Film deposition may be carried out by techniques commonly used in manufacture of solar cells, as exemplified by vapor deposition and selenization. An exemplary material include a compound semiconductor material which contains main constituent elements including a Ib element, a IIIb element and a IVb element and has a chalcopyrite structure. For example, a p-type semiconductor layer containing Cu (copper), at least one element selected from In (indium) and Ga (gallium), and at least one element selected from Se (selenium) and S (sulfur) may be deposited for the light-absorbing layer. More specifically, CuInSe₂, Cu(In,Ga)Se₂, or other compound semiconductor in which part of Se is substituted with S may be deposited. A CIS or CIGS solar cell is obtained by such manufacturing method, which enables the solar cell manufactured to have more excellent conversion efficiency.

Doping with Zn is also carried out in this step, and the region in part of the layer should be doped with Zn in this case. Doping with Zn can be carried out so that the concentration of Zn contained increases from the electrode layer 4 side in the layer thickness direction (so as to have a concentration gradient). It is particularly preferred for the neighborhood of the surface on the opposite side from the electrode layer 4 to be doped with Zn. Such manufacturing method enables a solar cell having more excellent properties such as conversion efficiency to be manufactured. The neighborhood of the surface on the opposite side from the electrode layer 4 as used herein refers to the area which is, for example, about 3 nm to 30 nm distant from the opposite side surface. The doping distance is not necessarily constant for the whole area, and partial variability is acceptable. The amount of doping with Zn is not particularly limited and is in the range of 1 at% to 15 at%. The method of doping with Zn is not particularly limited. For example, doping with Zn may be carried out by ion irradiation. The doping distance and doping amount can be controlled by adjusting the energy of the Zn ion to be irradiated. Doping with Zn may also be carried out by contact with a Zn-containing solution. The distance and amount of doping with Zn can be controlled by adjusting the concentration of the Zn-containing solution and the time for which the aluminum substrate is brought into contact with the solution. More uniform doping with Zn can be achieved by such manufacturing method. The doping distance can be further decreased. Doping with Zn can be more simply carried out by the immersion process, thus enabling the manufacturing method used to be low in manufacturing cost. The Zn-containing solution is not particularly limited as long as it is and may be, for example, a solution containing Zn ions. Specifically, it is desirable to use an aqueous solution containing at least one compound selected from the group consisting of, for example, sulfate of zinc (zinc sulfate), chloride of zinc (zinc chloride), iodide of zinc (zinc iodide), bromide of zinc (zinc bromide), nitrate of zinc (zinc nitrate) and acetate of zinc (zinc acetate). The concentration of the aqueous solution is not particularly limited. The aqueous solution desirably contains Zn ions at a concentration of 0.01 mol/L to 0.03 mol/L. At a concentration within this range, a better Zn-doped layer can be formed. The time of immersion in the Zn-containing solution is not particularly limited and may be set as appropriate for the required doping distance (or the necessary thickness of the Zn-doped layer).

It is preferred to further form a ZnMgO film with a thickness of 0.05 to 4 µm on the Zn-doped layer by sputtering.

The buffer layer 6 is a layer made of a material such as ZnO/CdS and has a total thickness of 0.05 to 4 µm.

Film deposition may be carried out by techniques commonly used in manufacture of solar cells, as exemplified by vapor deposition and sputtering.

The transparent electrode layer 7 is made of a material such as A1-doped ZnO or ITO (indium tin oxide) and has a thickness of 0.1 to 0.3 µm. Film deposition may be carried out by techniques commonly used in manufacture of solar cells, as exemplified by sputtering. For example, a translucent electrically-conductive material may be deposited. A film of indium tin oxide (ITO), ZnO, or both the materials may be deposited.

The output electrodes 8 and 9 are made of a material such as Al or Ni. In the case of forming the output electrodes, the material of these output electrodes is not particularly limited and materials commonly used for solar cells may be employed. For example, the output electrodes may be formed by disposing NiCr, Ag, Au, A1 or the like. A commonly used method may be employed in the formation of the output electrodes.

The substrate of the present invention exerts the same effects as the object of the present invention when used for the substrate of not only CIGS or CIS solar cells but also monocrystalline silicon solar cells, polycrystalline silicon solar cells, thin-film silicon solar cells, HIT solar cells, CdTe solar cells, multi-junction solar cells, space solar cells, dye-sensitized solar cells, organic thin-film solar cells, and solar cells utilizing the semiconductor quantum dot.

### EXAMPLES

The present invention is described below by way of examples and comparative examples. However, the present invention should not be construed as being limited to the following examples.

### Examples 1-1 to 1-13

Several types of aluminum ingots with an aluminum purity of 99.99 wt% were prepared and magnesium was added to adjust the magnesium concentration to thereby obtain aluminum rolled plates of 0.1 mm thickness having the aluminum alloy components as shown in Tables 1-1 and 1-2. The aluminum rolled plates were used to sequentially carry out the following treatments. Comparative Example 1 had the composition shown in Tables 1-1 and 1-2 by the addition of other elements. The aluminum alloy plates had a mirror-finished surface.

The intermetallic compounds in the aluminum alloy were identified by the analysis of each aluminum plate cut into a size of 25 millimeters square. The analysis method includes measuring the aluminum plate by the X-ray diffraction system RAD-rR manufactured by Rigaku Corporation and calculating the peak integrated diffraction intensities representing the respective phases detected.

As used herein, "the aluminum alloy substantially free from the components which are liable to form intermetallic compounds with aluminum" refers to an alloy in which the integrated diffraction intensities are not substantially calculated in cases where the main intermetallic compounds are measured by the X-ray diffraction system RAD-rR to calculate the peak integrated diffraction intensities representing the respective phases detected. Examples of the main intermetallic compounds include Al₃Fe, Al₆Fe, AlₘFe, α-AlFeSi, β-Al₅Fe-Si, and α-AlMnSi.

The tensile strength of the aluminum plate was measured according to JIS Z 2241 (method of tensile test for metallic materials) using Autograph (AGS-5KNH) manufactured by Shimadzu Corporation under the condition of a tensile speed of 2 mm/min.

### (1) Degreasing Treatment

The aluminum rolled plate was degreased by immersion in an acidic electrolytic solution containing 170 g/L of sulfuric acid at 60°C for 30 seconds, then rinsed with water, and the water was further removed with nip rollers.

### (2) Anodizing Treatment (Formation of porous Insulating Layer)

An anodized layer (insulating layer) was formed in any of various electrolytic cells shown in Tables 1-1 and 1-2. The thickness of the anodized film was adjusted so as to be shown on Table 1 with the electrolysis time. Then, rinsing with water and removal of the water with nip rollers were carried out.

### 1) Anodizing treatment in aqueous sulfuric acid solution

Anodizing treatment was carried out using an aqueous solution containing 170 g/L of sulfuric acid (and also containing 5 g/L of aluminum ions adjusted by the addition of aluminum sulfate) at a current density of 25 A/dm² and a solution temperature of 40°C. A direct current was used and the aluminum plate served as the anode.

### 2) Anodizing treatment in aqueous oxalic acid solution

Anodizing treatment was carried out using an aqueous solution containing 63 g/L of oxalic acid at a current density of 1 A/dm² and a solution temperature of 15°C. A direct current was used and the aluminum plate served as the anode.

### 3. Sealing Treatment

Use was made of an aqueous solution obtained by adding 0.05 mol/L of sodium tetraborate to an aqueous solution containing 0.5 mol/L of an aqueous boric acid solution. Sealing was carried out at a solution temperature of 20°C. A direct current was used, the aluminum plate of the present invention and the carbon electrode served as the anode and the counter electrode, respectively, and the distance between the aluminum plate and the counter electrode was 2 cm. A DC power supply with a constant voltage was used and the voltage between the aluminum plate and the counter electrode was set to 400V. The current flowed at a current density of 0.5 A/dm² for 1 minute from the beginning and gradually decreased to approach 0 A/dm² 5 minutes later. The total electrolysis time was 5 minutes. Then, the plate was rinsed with water and dried after removal of the water with nip rollers.

### Comparative Examples 1 and 2

The materials of the aluminum compositions shown in Tables 1-1 and 1-2 were used to carry out degreasing treatment, anodizing treatment and sealing treatment as in Example 1 under the conditions shown in Tables 1-1 and 1-2 as in Example 1, thus obtaining aluminum alloy substrates, which were then evaluated in the same manner. The results are shown in Tables 1-1 and 1-2.

### (4) Evaluation of Withstand Voltage

An aluminum electrode with a size of 5 cm × 4 cm was formed on the substrate obtained. The voltage was increased from 0 to 3 kV and the withstand voltage was evaluated by the voltage at which the leakage current exceeded 10 to 6 A/mm². A voltage of 500 V or more was rated A and a voltage of less than 500 V was rated C. The results are shown in Tables 1-1 and 1-2.

### (5) Evaluation of Strength at Elevated Temperatures

The aluminum alloy was heated at 550°C for 1 hour, after which the tensile strength of the aluminum alloy was measured. A tensile strength of 100 MPa or more was rated A and a tensile strength of less than 100 MPa was rated C.

### Example 2

A thin-film layer was formed by the following method on the aluminum substrates prepared by the methods of Examples 1-1 and 1-13, Comparative Examples 1 and 2 thus manufacturing thin-film solar cells.
1) First, an Mo film (with a thickness of 1 µm) serving as a first electrode layer was formed on the anodized aluminum substrates in Examples 1-1 and 1-12. The Mo film was formed by vapor deposition. Then, a Cu(In,Ga)Se₂ film (with a thickness of 2 µm) serving as a p-type semiconductor layer was deposited on the Mo film by vapor deposition to form a laminate including the substrate, the first electrode layer (backside electrode layer) and the p-type semiconductor layer.
   Then, an aqueous solution containing zinc sulfate (ZnSO₄) which is a Zn-containing compound (salt) was prepared (the concentration of the Zn ions in the solution was adjusted to 0.025 mol/L). The thus prepared aqueous solution was held at 85°C in a temperature-controlled bath and the laminate was immersed in the bath for about 3 minutes.
2) Then, the laminate was rinsed with pure water and heat-treated at 400°C for 10 minutes in a nitrogen atmosphere. A Zn_{0.9} ·Mg_{0.1} layer (with a thickness of 100 nm) serving as an n-type semiconductor layer was formed on the p-type semiconductor layer of the laminate by two-source sputtering using a ZnO target and an MgO target. In this process, a radio frequency with a power of 200 W was applied to the ZnO target and a radio frequency with a power of 120 W was applied to the MgO target in an argon gas atmosphere (with a gas pressure of 2.66 Pa (2 × 10⁻² Torr)).
3) Then, an ITO film (with a thickness of 100 nm) which is a translucent electrically-conductive film and serves as the second electrode layer (transparent electrode layer) was formed by sputtering on the n-type semiconductor layer. The ITO film was formed by applying a radio frequency with a power of 400W to the target in an argon gas atmosphere (with a gas pressure of 1.07 Pa (8 × 10⁻³ Torr)). Finally, an NiCr film and an Ag film were deposited on the Mo film and the ITO film by electron beam evaporation to form output electrodes, thus manufacturing a solar cell.

### Example 3

A substrate was prepared by the method of Example 1-1 except that sealing treatment was carried out by immersion in an aqueous solution containing 2.5 wt% of sodium dihydrogenphosphate at 60°C for 20 seconds in place of sealing treatment in the boric acid-based aqueous solution in paragraph (3) of Example 1-1. The resulting substrate was evaluated for the withstand voltage. The result was "A", which showed that the substrate was good for use as a solar cell substrate.

### Example 4

A substrate was prepared by the method of Example 1-1 except that sealing treatment was carried out by immersion in an aqueous solution containing 2.5 wt% of sodium hexafluorozirconate at 60°C for 20 minutes in place of sealing treatment in the boric acid-based aqueous solution in paragraph (3) of Example 1-1. The resulting substrate was evaluated for the withstand voltage. The result was "A", which showed that the substrate was good for use as a solar cell substrate.

### Example 5

A substrate was prepared by the method of Example 1-1 except that sealing treatment was carried out by immersion in an aqueous solution containing 2.5 wt% of sodium hexafluorozirconate and an aqueous solution containing 2.5 wt% of sodium dihydrogenphosphate at 60°C for 20 seconds in place of sealing treatment in the boric acid-based aqueous solution in paragraph (3) of Example 1-1. The resulting substrate was evaluated for the withstand voltage. The result was "A", which showed that the substrate was good for use as a solar cell substrate.

### Example 6

A substrate was prepared by the method of Example 1-1 except that sealing treatment was carried out by immersion in an aqueous solution containing 2.5 wt% of No. 3 sodium silicate at 50°C for 10 seconds in place of sealing treatment in the boric acid-based aqueous solution in paragraph (3) of Example 1-1. The resulting substrate was evaluated for the withstand voltage. The result was "A", which showed that the substrate was good for use as a solar cell substrate.

**Table 1-1**

| | | | Examples | | | | | | | | | |
|---|---|---|---|---|---|---|---|---|---|---|---|---|
| | | | EX 1-1 | EX 1-2 | EX 1-3 | EX 1-4 | EX 1-5 | EX 1-6 | EX 1-7 | EX 1-8 | EX 1-9 | EX 1-10 |
| Aluminum component wt% | Si | | 0.003 | 0.003 | 0.003 | 0.004 | 0.004 | 0.002 | 0.003 | 0.003 | 0.003 | 0.003 |
| | Fe | | 0.003 | 0.003 | 0.003 | 0.004 | 0.004 | 0.004 | 0.003 | 0.003 | 0.003 | 0.003 |
| | Cu | | 0.000 | 0.000 | 0.000 | 0.000 | 0.000 | 0.001 | 0.000 | 0.000 | 0.000 | 0.000 |
| | Mn | | 0.000 | 0.000 | 0.000 | 0.000 | 0.000 | 0.000 | 0.000 | 0.000 | 0.000 | 0.000 |
| | Mg | | 4.0 | 3.0 | 6.0 | 4.0 | 4.5 | 3.5 | 4.0 | 4.0 | 4.0 | 4.0 |
| | Zn | | 0.001 | 0.001 | 0.001 | 0.001 | 0.001 | 0.000 | 0.001 | 0.001 | 0.001 | 0.001 |
| | Cr | | 0.000 | 0.000 | 0.000 | 0.000 | 0.000 | 0.000 | 0.000 | 0.000 | 0.000 | 0.000 |
| | Ti | | 0.001 | 0.001 | 0.001 | 0.001 | 0.001 | 0.000 | 0.001 | 0.001 | 0.001 | 0.001 |
| | Pb | | 0.0001 | 0.0001 | 0.0001 | 0.0001 | 0.0000 | 0.0000 | 0.0001 | 0.0001 | 0.0001 | 0.0001 |
| | Ni | | 0.0001 | 0.0001 | 0.0001 | 0.0001 | 0.0000 | 0.0000 | 0.0001 | 0.0001 | 0.0001 | 0.0001 |
| | Ga | | 0.0000 | 0.0000 | 0.0000 | 0.0001 | 0.0000 | 0.0000 | 0.0000 | 0.0000 | 0.0000 | 0.0000 |
| | Zr | | 0.0000 | 0.0000 | 0.0000 | 0.0001 | 0.0000 | 0.0000 | 0.0000 | 0.0000 | 0.0000 | 0.0000 |
| | v | | 0.0000 | 0.0000 | 0.0000 | 0.0001 | 0.0000 | 0.0000 | 0.0000 | 0.0000 | 0.0000 | 0.0000 |
| | Sc | | 0.0000 | 0.0000 | 0.0000 | 0.0001 | 0.0000 | 0.0000 | 0.0000 | 0.0000 | 0.0000 | 0.0000 |
| | B | | 0.0001 | 0.0001 | 0.0001 | 0.0001 | 0.0000 | 0.0002 | 0.0001 | 0.0001 | 0.0001 | 0.0001 |
| | Na | | 0.0010 | 0.0000 | 0.0000 | 0.0000 | 0.0000 | 0.0000 | 0.0000 | 0.0000 | 0.0000 | 0.0000 |
| Inter-metallic compound Unit:Kcounts * -: undetected | Al₃Fe | 24.1° | - | - | - | - | - | - | - | - | - | - |
| | Al₆Fe | 18.0° | - | - | - | - | - | - | - | - | - | - |
| | AlmFe | 25.7° | - | - | - | - | - | - | - | - | - | - |
| | α-AlFeSi | 42.0° | - | - | - | - | - | - | - | - | - | - |
| | β-Al₅Fe-Si | 17.0° | - | - | - | - | - | | - | - | - | - |
| | α-AlMnsi | 41.6° | - | - | - | - | - | - | - | - | - | - |
| Anodizing treatment | In aqueous sulfuric acid (µm) | | 14 | 14 | 14 | 14 | 14 | 19 | 6 | 9 | 19 | 25 |
| | In aqueous oxalic acid (µm) | | - | - | - | - | - | - | - | - | - | - |
| Sealing treatment | Sealing using boric acid | | Done | Done | Done | Done | Done | Done | Done | Done | Done | Done |
| Evaluation result | Tensile strength at room temperature Mpa | | 400 | 350 | 570 | 400 | 460 | 370 | 400 | 400 | 400 | 400 |
| | Tensile strength Mpa (550°C 1 hour) | | 180 | 150 | 210 | 180 | 190 | 160 | 180 | 180 | 180 | 180 |
| | Strength at elevated temperatures | | A | A | A | A | A | A | A | A | A | A |
| | Evaluation of withstand voltage (500V) | | A | A | A | A | A | A | A | A | A | A |

**Table 1-2**

| | | | Examples | | | Comparative Examples | |
|---|---|---|---|---|---|---|---|
| | | | EX 1-11 | EX 1-12 | EX 1-13 | CE 1 | CE 2 |
| Aluminum component wt% | Si | | 0.003 | 0.003 | 0.003 | 0.058 | 0.003 |
| | Fe | | 0.003 | 0.003 | 0.003 | 0.300 | 0.003 |
| | Cu | | 0.000 | 0.000 | 0.000 | 0.014 | 0.000 |
| | Mn | | 0.000 | 0.000 | 0.000 | 0.002 | 0.000 |
| | Mg | | 4.0 | 4.0 | 4.0 | 0.01 | 4.0 |
| | Zn | | 0.001 | 0.001 | 0.001 | 0.002 | 0.001 |
| | Cr | | 0.000 | 0.000 | 0.000 | 0.001 | 0.000 |
| | Ti | | 0.001 | 0.001 | 0.001 | 0.029 | 0.001 |
| | Pb | | 0.0001 | 0.0001 | 0.0001 | 0.0001 | 0.0001 |
| | Ni | | 0.0001 | 0.0001 | 0.0001 | 0.0001 | 0.0001 |
| | Ga | | 0.0000 | 0.0000 | 0.0000 | 0.0001 | 0.0000 |
| | Zr | | 0.0000 | 0.0000 | 0.0000 | 0.0001 | 0.0000 |
| | v | | 0.0000 | 0.0000 | 0.0000 | 0.0001 | 0.0000 |
| | Sc | | 0.0000 | 0.0000 | 0.0000 | 0.0001 | 0.0000 |
| | B | | 0.0001 | 0.0001 | 0.0001 | 0.0001 | 0.0001 |
| | Na | | 0.0000 | 0.0000 | 0.0000 | 0.0000 | 0.0000 |
| Inter- | Al₃Fe | 24.1° | - | - | - | 13.7 | - |
| metallic | Al₆Fe | 18.0° | - | - | - | 1 | - |
| compound | AlmFe | 25.7° | - | - | - | - | - |
| Unit:Kcounts | α-AlFeSi | 42.0° | - | - | - | - | - |
| * -: | β-Al₅Fe-Si | 17.0° | - | - | - | - | - |
| undetected | α-AlMnSi | 41.6° | - | - | - | - | - |
| Anodizing treatment | In aqueous sulfuric acid (µm) | | - | - | - | 14 | 1 |
| | In aqueous oxalic acid (µm) | | 9 | 12 | 18 | - | - |
| Sealing treatment | Sealing using boric acid | | Done | Done | Done | Done | Done |
| Evaluation result | Tensile strength at room temperature Mpa | | 400 | 400 | 400 | 150 | 400 |
| | Tensile strength Mpa (550°) 1 hour) | | 180 | 180 | 180 | 50 | 180 |
| | Strength at elevated temperatures | | A | A | A | C | A |
| | Evaluation of withstand voltage (500V) | | A | A | A | C | C |

## Claims

1. A substrate comprising:
an oxide film having insulating properties and a thickness of more than 1 µm to 30 µm on a surface of an aluminum alloy containing 2.0 to 7.0 wt% of magnesium, the balance being aluminum and inevitable impurities.

2. The substrate according to claim 1, wherein the oxide film having the insulating properties is a porous anodized film with a thickness of 5 to 30 µm.

3. The substrate according to claim 1 or 2, wherein the porous anodized film is one obtained by anodizing the aluminum alloy in an aqueous sulfuric or oxalic acid solution.

4. The substrate according to any one of claims 1 to 3, wherein the oxide film having the insulating properties is one obtained by forming a porous anodized film through anodization of the aluminum alloy in an aqueous sulfuric or oxalic acid solution, and sealing the porous anodized film in an aqueous boric acid solution containing sodium borate.

5. A substrate comprising:
an insulating layer having a thickness of more than 1 µm to 30 µm formed on a surface of an aluminum alloy containing 2.0 to 7.0 wt% of magnesium, the balance being aluminum and inevitable impurities.

6. A solar cell substrate comprising:
an aluminum alloy containing 2.0 to 7.0 wt% of magnesium, the balance being aluminum and inevitable impurities; and
an insulating layer having a thickness of more than 1 µm to 30 µm formed on a surface of the aluminum alloy.

7. A solar cell substrate obtained by a process which comprises:
an aluminum alloy containing 2.0 to 7.0 wt% of magnesium, the balance being aluminum and inevitable impurities, in an aqueous sulfuric or oxalic acid solution to form a porous anodized film with a thickness of 5 to 30 µm; and
sealing the porous anodized film in an aqueous boric acid solution.

8. A solar cell having the substrate according to any one of claims 1 to 7.

9. A thin-film solar cell comprising the substrate according to any one of claims 1 to 7 and a light-absorbing layer formed on the substrate, with a backside electrode layer interposed between the substrate and the light-absorbing layer.

10. The thin-film solar cell according to claim 9, wherein the light-absorbing layer contains a compound selected from the group consisting of CdS/CdTe, CIS, and CIGS.

11. A method of manufacturing a thin-film solar cell comprising the steps of:
continuously feeding an aluminum alloy plate which is wound into a roll and contains 2.0 to 7.0 wt% of magnesium, the balance being aluminum and inevitable impurities;
subjecting the fed aluminum alloy plate to anodizing treatment, rinsing with water, sealing treatment, rinsing with water and drying;
winding the aluminum alloy plate having been dried into a roll; and
continuously feeding the aluminum alloy plate having been wound into the roll to form a backside electrode layer and a light-absorbing layer.
